# FASCICULE DE BREVET EUROPEEN

(11) **EP 3 828 936 B1**
(45) Date de publication et mention de la délivrance du brevet: **31.08.2022**
(21) Numéro de dépôt: 20209479.3
(22) Date de dépôt: 24.11.2020
(51) Int. Cl.: H01L 27/146

(54) **PROCÉDÉ DE FABRICATION D'UN DISPOSITIF DE DÉTECTION COMPORTANT UNE ÉTAPE DE REPORT ET DE COLLAGE DIRECT D'UNE COUCHE MINCE MUNIE D'UN MATERIAU GETTER**
VERFAHREN ZUR HERSTELLUNG EINES ERKENNUNGSGERÄTS, EINSCHLIESSLICH EINES SCHRITTS DER ÜBERTRAGUNG UND DIREKTEN VERBINDUNG EINER MIT EINEM MATERIAL HERGESTELLTEN DÜNNEN GETTER-SCHICHT
METHOD OF MANUFACTURING A DETECTION DEVICE INCLUDING A STEP OF TRANSFERRING AND DIRECT BONDING OF A THIN LAYER PROVIDED WITH A GETTER MATERIAL

(30) Priorité: 27.11.2019 FR 1913331
(43) Date de publication de la demande: 02.06.2021
(73) Titulaire: COMMISSARIAT À L'ÉNERGIE ATOMIQUE ET AUX ÉNERGIES ALTERNATIVES, 75015 Paris (FR)
(72) Inventeur: BECKER, Sébastien, 38054 GRENOBLE cedex 09 (FR); FOURNEL, Frank, 38054 GRENOBLE cedex 09 (FR)
(74) Mandataire: INNOV-GROUP

(56) Documents cités:
- US-A1- 2018 321 087

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité hermétique, dans laquelle est également situé un matériau getter. L'invention s'applique notamment au domaine de l'imagerie infrarouge et de la thermographie.

### ÉTAT DE LA TECHNIQUE ANTÉRIEURE

Un dispositif de détection de rayonnement électromagnétique, par exemple infrarouge ou térahertz, peut comprendre une matrice de détecteurs thermiques comportant chacun une portion absorbante apte à absorber le rayonnement électromagnétique à détecter.

Dans le but d'assurer l'isolation thermique des détecteurs thermiques, les portions absorbantes se présentent habituellement sous la forme de membranes suspendues au-dessus du substrat par des piliers d'ancrage, et isolées thermiquement de celui-ci par des bras de maintien et d'isolation thermique. Ces piliers d'ancrage et bras d'isolation thermique présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par ces derniers en réponse à l'absorption du rayonnement électromagnétique à détecter. Le circuit de lecture comporte différents niveaux d'interconnexion électrique formés de lignes métalliques séparées les unes des autres par des couches diélectriques dites inter-métal. Au moins un plot de connexion électrique du circuit de lecture est disposé sur le substrat de telle manière qu'il puisse être contacté depuis l'extérieur du dispositif de détection.

Le document EP3239670A1 décrit un procédé de fabrication d'un dispositif de détection qui utilise des couches sacrificielles minérales pour réaliser les détecteurs thermiques, lesquelles sont ensuite supprimées par une gravure chimique humide. Une portion d'un matériau getter, par exemple en titane, est située sous chaque membrane absorbante, et est protégée de la gravure chimique humide par une couche mince sacrificielle carbonée, laquelle est ensuite supprimée par une gravure chimique sèche spécifique. Les couches sacrificielles minérales recouvrent donc momentanément la couche mince sacrificielle carbonée. Cependant, il existe un besoin d'améliorer la tenue mécanique de l'empilement obtenu lors des différentes étapes du procédé de fabrication, en particulier lorsque les étapes de planarisation des couches minces sacrificielles sont effectuées, et de limiter les risques de dégradation structurelle des éléments ou couches formant cet empilement.

Le document EP3399290A1 décrit un autre procédé de fabrication d'un dispositif de détection, dans lequel la structure d'encapsulation qui définit la cavité hermétique est formée par report d'un capot fin. Plus précisément, un premier empilement est réalisé qui comporte les détecteurs thermiques ainsi que des piliers périphériques présentant une surface de scellement périphérique réalisée en un matériau métallique, par exemple en cuivre. Un deuxième empilement est réalisé, qui comporte une couche mince formant le capot fin munie d'une portion getter ainsi que d'une surface de scellement périphérique réalisée en un matériau métallique, par exemple en cuivre. Ce deuxième empilement est reporté sur le premier, et les surfaces de scellement périphérique sont mises en contact et collées l'une à l'autre. La portion getter est recouvert d'une couche de protection pour éviter sa dégradation lors d'une gravure chimique humide mise en œuvre pour supprimer les couches sacrificielles minérales. Cependant, il existe un besoin de simplifier la structure du dispositif de détection d'une part, et de simplifier le procédé de fabrication d'autre part, notamment en évitant l'utilisation du cuivre pour le collage des deux empilements dans la mesure où ce matériau peut ne pas être disponible dans certaines filières technologiques.

### EXPOSÉ DE L'INVENTION

L'invention a pour objectif de remédier au moins en partie aux inconvénients de l'art antérieur. Pour cela, l'objet de l'invention est un procédé de fabrication d'un dispositif de détection d'un rayonnement électromagnétique, comportant les étapes suivantes :
- réalisation d'un premier empilement comportant : au moins un détecteur thermique reposant sur un premier substrat, destiné à détecter le rayonnement électromagnétique, et recouvert par au moins une couche sacrificielle minérale réalisée en un matériau minéral apte à être supprimé par une première gravure chimique ; et une couche mince d'encapsulation, s'étendant au-dessus du détecteur thermique et participant à délimiter une cavité dans laquelle se situe le détecteur thermique, comportant une partie supérieure reposant sur la couche sacrificielle minérale ; au moins une échancrure dite latérale s'étendant au travers de la partie supérieure de la couche mince d'encapsulation et d'une partie de la couche sacrificielle minérale, et étant située à distance du détecteur thermique dans un plan parallèle au plan du premier substrat ;
- réalisation d'un deuxième empilement comportant : une couche mince dite de maintien, transparente au rayonnement électromagnétique, reposant sur un substrat support ; au moins une portion getter disposée sur la couche mince de maintien et recouvrant partiellement celle-ci ; et une couche mince de protection, recouvrant la portion getter, réalisée en un matériau carboné apte à être supprimé par une deuxième gravure chimique ;
- assemblage des premier et deuxième empilements, par mise en contact et collage direct de la couche mince de maintien sur la partie supérieure de la couche mince d'encapsulation, de sorte que la portion getter est située dans l'échancrure latérale ; puis
- réalisation d'au moins un évent de libération au travers de la couche mince de maintien et de la partie supérieure de la couche mince d'encapsulation, débouchant sur la couche sacrificielle minérale ; puis
- suppression de la couche sacrificielle minérale par la première gravure chimique ;
- suppression de la couche mince de protection par la deuxième gravure chimique ;
- dépôt d'une couche mince de scellement sur la couche mince de maintien de manière à obturer l'évent de libération.

Certains aspects préférés mais non limitatifs de ce procédé sont les suivants.

La couche mince d'encapsulation peut s'étendre continûment au-dessus et autour du détecteur thermique. Elle peut ainsi comporter la partie supérieure ainsi qu'une partie périphérique qui s'étend au-travers de la couche sacrificielle minérale et repose sur le premier substrat.

L'étape d'assemblage peut être effectuée à température ambiante avec une pression de niveau de vide inférieure ou égale à 10-5 Pa.

Le matériau carboné de la couche mince de protection peut être choisi parmi le carbone amorphe et le polyimide.

L'échancrure latérale peut présenter des dimensions telles que, lors de l'étape d'assemblage, la couche mince de protection est distante de la couche sacrificielle minérale, de préférence dans un plan parallèle au plan du substrat et suivant un axe orthogonal au plan du substrat.

La couche mince d'encapsulation peut être réalisée à base de silicium, et la couche mince de maintien peut être réalisée à base de silicium ou de germanium.

La couche mince d'encapsulation peut présenter une surface de contact en silicium, et la couche mince de maintien peut présenter une surface de contact en silicium ou en germanium. L'étape d'assemblage par collage direct peut comporter une activation desdites surfaces de contact par gravure partielle par faisceau d'ions et un collage sous vide.

La partie supérieure de la couche mince d'encapsulation peut être formée d'une sous-couche réalisée en silicium et d'une première sous-couche de collage, et la couche mince de maintien peut être formée d'une sous-couche réalisée à base de silicium ou en germanium et d'une deuxième sous-couche de collage, les deux sous-couches de collage étant transparentes au rayonnement électromagnétique à détecter. L'étape d'assemblage par collage direct peut comporter la mise en contact des deux sous-couches métalliques l'une contre l'autre sous vide.

Lesdites sous-couches de collage peuvent présenter chacune une épaisseur inférieure ou égale à 1nm.

Lesdites sous-couches de collage peuvent être réalisées en un matériau métallique ou en carbone amorphe.

Le premier empilement peut comporter plusieurs matrices de détecteurs thermiques, chaque matrice étant située dans une cavité distincte délimitée au moins en partie par une couche mince d'encapsulation, la couche mince de maintien venant au contact des parties supérieures des différentes couches minces d'encapsulation.

La portion getter peut être disposée en regard d'un détecteur thermique dit de compensation destiné à ne pas recevoir le rayonnement électromagnétique, la portion getter étant opaque au rayonnement électromagnétique.

L'invention porte également sur un dispositif de détection d'un rayonnement électromagnétique, donc une partie de la structure d'encapsulation est une couche mince de maintien dont sa face supérieure est plane, ce qui est avantageux lorsqu'on souhaite y ajouter des composants optiques (filtres...). Il comporte :
∘ un substrat ;
∘ au moins un détecteur thermique reposant sur le substrat, destiné à détecter le rayonnement électromagnétique ;
∘ une couche mince d'encapsulation, s'étendant au-dessus du détecteur thermique et participant à délimiter une cavité dans laquelle se situe le détecteur thermique, comportant une partie supérieure ;
   • au moins une échancrure dite latérale s'étendant au travers de la partie supérieure de la couche mince d'encapsulation, et située à distance du détecteur thermique dans un plan parallèle au plan du substrat ;
∘ une couche mince dite de maintien, transparente au rayonnement électromagnétique, reposant au contact de la partie supérieure de la couche mince d'encapsulation, la couche mince de maintien présentant une face supérieure plane opposée au substrat ;
∘ au moins une portion getter assemblée à la couche mince de maintien et disposée dans l'échancrure latérale ;
∘ au moins un évent de libération s'étendant au travers de la couche mince de maintien et de la partie supérieure de la couche mince d'encapsulation ;
une couche mince de scellement recouvrant la couche mince de maintien et obturant l'évent de libération.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1H illustrent différentes étapes d'un procédé de fabrication d'un dispositif de détection selon un premier mode de réalisation dans lequel le collage direct est de type SAB (pour *Surface Activated Bonding,* en anglais) ;
la figure 2 est une vue en coupe, schématique et partielle, d'un dispositif de détection obtenu selon une variante du premier mode de réalisation, dans laquelle la portion getter est disposée en regard d'un détecteur thermique de compensation ;
les figures 3A à 3F illustrent différentes étapes d'un procédé de fabrication d'un dispositif de détection selon un deuxième mode de réalisation dans lequel le collage direct est de type ADB (pour *Atomic Diffusion Bonding,* en anglais).

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte d'une manière générale sur un procédé de fabrication d'un dispositif de détection de rayonnement électromagnétique adapté à détecter un rayonnement infrarouge ou térahertz. Ce dispositif de détection comporte un ou plusieurs détecteurs thermiques, ainsi qu'au moins un matériau à effet getter, situés dans une cavité hermétique. La cavité hermétique est délimitée par une structure d'encapsulation, laquelle est formée de plusieurs couches minces transparentes au rayonnement électromagnétique à détecter, dont notamment une couche mince d'encapsulation qui s'étend continûment au-dessus du ou des détecteurs thermiques, et éventuellement continûment au-dessus et autour de ces derniers. Par couche mince, on entend une couche formée par les techniques de dépôt de matériau de la microélectronique, dont l'épaisseur est de préférence inférieure ou égale à 10µm. Par ailleurs, une couche mince est dite transparente lorsqu'elle présente un coefficient de transmission supérieur ou égal à 50%, de préférence à 75%, voire à 90% pour une longueur d'onde centrale de la gamme spectrale du rayonnement électromagnétique à détecter.

D'une manière générale, un matériau à effet getter est un matériau destiné à être exposé à l'atmosphère de la cavité hermétique et apte à réaliser un pompage gazeux par absorption et/ou adsorption. Il s'agit d'un matériau métallique qui peut être choisi parmi le titane, le zirconium, le vanadium, le chrome, le cobalt, le fer, le manganèse, le palladium, le baryum et/ou l'aluminium, voire un alliage de ces métaux tel que le TiZrV.

Par ailleurs, le procédé de fabrication comporte une étape de réalisation du ou des détecteurs thermiques au moyen d'au moins une couche sacrificielle dite minérale, réalisée en un matériau minéral ou inorganique. Il s'agit ici d'un matériau diélectrique à base de silicium permettant également la réalisation d'une couche diélectrique inter-métal du circuit de lecture, c'est-à-dire un matériau électriquement isolant, avec par exemple une constante diélectrique, ou permittivité relative, inférieure ou égale à 3,9, limitant ainsi la capacité parasite entre les interconnexions. Ce matériau minéral ne comporte pas de chaînes carbonées, et peut être un oxyde de silicium SiOx ou un nitrure de silicium SiₓN_{y}, voire un matériau organosilicié tel que du SiOC, du SiOCH, ou d'un matériau de type verre fluoré tel que du SiOF. La couche sacrificielle minérale peut être supprimée par une gravure chimique humide telle qu'une attaque chimique en milieu acide, par exemple à l'acide fluorhydrique en phase vapeur (HF vapeur). Par gravure humide, on entend d'une manière générale que l'agent de gravure se présente en phase liquide ou en phase vapeur, et ici, de préférence, en phase vapeur.

Selon l'invention, le matériau getter forme une portion, ou plot, dite getter disposée sur une couche mince de maintien, laquelle est reportée et assemblée par collage direct à la couche mince d'encapsulation. Le collage direct (*direct bonding,* en anglais), parfois appelé collage moléculaire ou collage par adhésion moléculaire, est la solidarisation de deux surfaces mises au contact l'une de l'autre, sans apport d'un matériau collant spécifique tel qu'une résine ou un polymère, mais par le biais des forces attractives d'interaction atomique ou moléculaire entre les surfaces à coller telles que des forces de Van der Waals ou des liaisons covalentes ou métalliques. Il s'agit d'un collage spontané à température ambiante. La température ambiante peut être une température inférieure ou égale à 40°C, par exemple égale à 25°C environ. Le collage direct peut être assisté en température, de manière à augmenter l'énergie de collage et ainsi renforcer l'adhérence des surfaces et donc l'herméticité de la cavité, par exemple par des recuits effectués après l'étape de collage à température ambiante.

De plus, dans la mesure où la ou les couches sacrificielles minérales sont supprimées à la suite de cette étape de report et de collage direct, la portion getter est revêtue d'une couche mince de protection en un matériau carboné. Un matériau carboné est un matériau formé d'au moins un type d'espèce chimique comportant des atomes de carbones. Il peut ainsi s'agir d'un matériau minéral tel que du carbone amorphe, éventuellement de type DLC (pour *Diamond Like Carbon,* en anglais), ou un matériau organique tel que du polyimide. Le carbone de type DLC est du carbone amorphe à fort taux d'hybridation en carbone sp³. De préférence, le matériau carboné ne comporte pas de silicium, de manière à éviter la présence d'éventuels résidus à la suite de l'étape de suppression de cette couche sacrificielle. La couche mince de protection est ainsi sensiblement inerte vis-à-vis de la gravure chimique humide effectuée pour supprimer la couche sacrificielle minérale. Par sensiblement inerte, on entend que le matériau carboné ne réagit sensiblement pas avec l'agent de gravure utilisé lors de l'étape de suppression de la couche sacrificielle minérale, voire réagit peu de sorte que la couche mince de protection, à l'issue de cette étape de suppression, recouvre toujours entièrement le matériau getter. La couche mince de protection est adaptée à être supprimée par une gravure chimique telle qu'une gravure chimique sèche dont un agent de gravure est par exemple de l'oxygène contenu dans un plasma.

Lors de l'étape de report, pour permettre l'introduction au sein de la cavité de la portion getter protégée par le matériau carboné, une échancrure latérale est réalisée de sorte qu'elle s'étende vers le substrat de lecture au travers de la couche mince d'encapsulation et d'une partie de la couche sacrificielle minérale. Cette échancrure est dite latérale dans la mesure où elle est distante, dans un plan parallèle au substrat, vis-à-vis du ou des détecteurs thermiques destinés à recevoir le rayonnement électromagnétique.

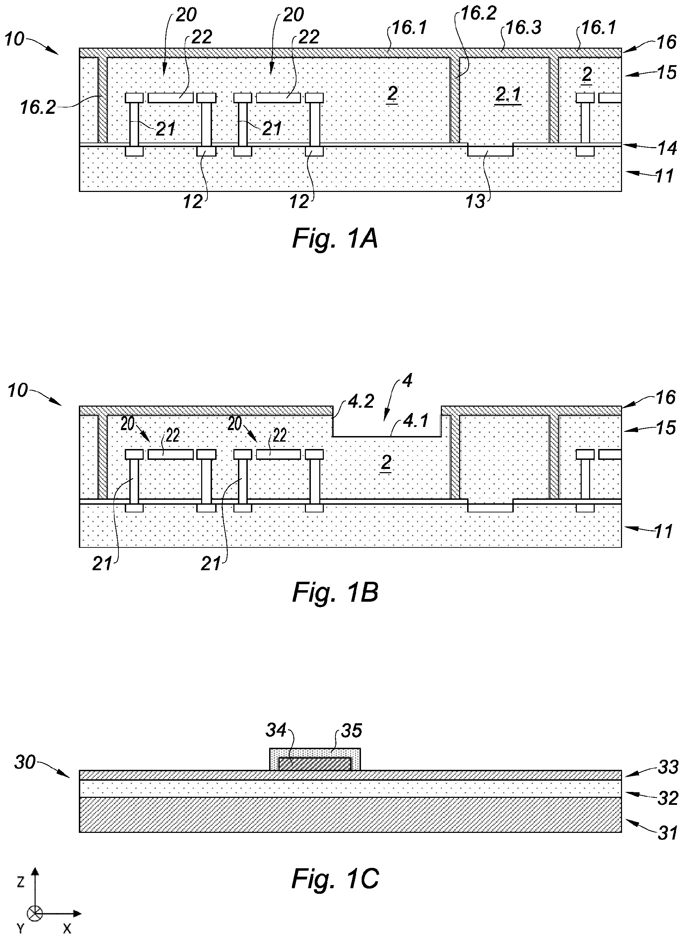

Les figures 1A à 1F illustrent différentes étapes d'un procédé de fabrication d'un dispositif de détection 1 selon un premier mode de réalisation dans lequel le collage direct est de type SAB (*Surface Activated Bonding*)*.* Par souci de clarté, seule une partie du dispositif de détection 1 est représentée sur les figures. Dans cet exemple, le procédé permet de fabriquer de manière simultanée plusieurs dispositifs de détection 1 de préférence identiques entre eux.

A titre d'exemple, les détecteurs thermiques 20 sont ici adaptés à détecter un rayonnement infrarouge dans la gamme LWIR (*Long Wavelength Infrared,* en anglais) dont la longueur d'onde est comprise entre 8µm et 14µm environ. Chaque dispositif de détection 1 comporte un ou plusieurs détecteurs thermiques 20, et ici une matrice de détecteurs thermiques 20 identiques, connectés à un circuit de lecture situé dans le substrat 11 (dit alors substrat de lecture), et situés dans une même cavité hermétique 2. Les détecteurs thermiques 20 forment ainsi des pixels sensibles agencés périodiquement, et peuvent présenter une dimension latérale dans le plan du substrat de lecture 11, de l'ordre de quelques dizaines de microns, par exemple égale à 10µm environ voire moins. De plus, la couche mince d'encapsulation s'étend ici continûment au-dessus et autour des détecteurs thermiques. Cependant, d'autres configurations de la couche mince d'encapsulation sont possibles.

On définit ici et pour la suite de la description un repère direct tridimensionnel XYZ, où le plan XY est sensiblement parallèle au plan du substrat de lecture 11, l'axe Z étant orienté suivant une direction sensiblement orthogonale au plan du substrat de lecture 11 en direction des détecteurs thermiques 20. Les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan XY. Par ailleurs, les termes « inférieur » et « supérieur » s'entendent comme étant relatifs à un positionnement croissant lorsqu'on s'éloigne du substrat de lecture 11 suivant la direction +Z.

En référence à la fig. 1A, on réalise un premier empilement 10 comportant :
- un premier substrat 11, dit substrat de lecture ;
- au moins une matrice de détecteurs thermiques 20 reposant sur le substrat de lecture 11, destinés à détecter le rayonnement électromagnétique, et recouverts par au moins une couche sacrificielle minérale 15 ;
- une couche mince d'encapsulation 16, s'étendant continûment au-dessus de la matrice de détecteurs thermiques 20 suivant l'axe Z et autour de celle-ci dans le plan XY.

Dans cet exemple, plusieurs matrices de détecteurs thermiques 20 reposent sur le substrat de lecture 11, et sont entourées chacune par une même couche mince d'encapsulation 16 destinée à former ensuite des couches minces d'encapsulation distinctes les unes des autres. Chaque couche mince d'encapsulation 16 est alors destinée à délimiter une cavité 2 logeant ici une matrice de détecteurs thermiques 20.

Le substrat de lecture 11 est réalisé à base de silicium, et est formé d'un substrat support contenant le circuit de lecture (non représenté) adapté à commander et lire les détecteurs thermiques 20. Le circuit de lecture se présente ici sous la forme d'un circuit intégré CMOS. Il comporte entre autres des portions de lignes conductrices séparées les unes des autres par des couches isolantes inter-métal réalisées en un matériau diélectrique, par exemple un matériau minéral à base de silicium tel qu'un oxyde de silicium SiOₓ, un nitrure de silicium SiNₓ, entre autres. Des portions conductrices 12 affleurent la surface du substrat support, et assurent la connexion électrique des piliers d'ancrage 21 des détecteurs thermiques 20 au circuit de lecture. De plus, une ou plusieurs portions de connexion 13 affleurent ici la surface du substrat support, et permettent de connecter le circuit de lecture à un dispositif électronique externe.

Le substrat de lecture 11 peut comporter un réflecteur (non représenté) disposé en regard de chaque détecteur thermique 20. Le réflecteur peut être formé par une portion d'une ligne conductrice du dernier niveau d'interconnexion, celle-ci étant réalisée en un matériau adapté à réfléchir le rayonnement électromagnétique à détecter. Il s'étend en regard de la membrane absorbante 22 du détecteur thermique 20, et est destiné à former avec celle-ci une cavité interférentielle quart d'onde vis-à-vis du rayonnement électromagnétique à détecter.

Enfin, le substrat de lecture 11 comporte ici une couche de protection 14 de manière à recouvrir notamment la couche isolante inter-métal supérieure. Cette couche de protection 14 correspond ici à une couche d'arrêt de gravure réalisée en un matériau sensiblement inerte à l'agent de gravure chimique utilisé ultérieurement pour supprimer les différentes couches sacrificielles minérales 15, par exemple au milieu HF en phase vapeur. Cette couche de protection 14 forme ainsi une couche hermétique et chimiquement inerte, et électriquement isolante pour éviter tout court-circuit entre les piliers d'ancrage 21. Elle permet ainsi d'éviter que les couches isolantes inter-métal sous-jacentes ne soient gravées lors de cette étape de suppression des couches sacrificielles minérales 15. Elle peut être formée en un oxyde ou nitrure d'aluminium, voire en trifluorure d'aluminium, ou encore en silicium amorphe non intentionnellement dopé. La couche de protection 14 ne recouvre pas les portions de connexion 13, de manière à permettre une connexion électrique de celles-ci à un dispositif électrique externe.

On réalise ensuite les détecteurs thermiques 20 sur le substrat de lecture 11. Ces étapes de réalisation sont identiques ou similaires à celles décrites notamment dans le document EP3239670A1. Les détecteurs thermiques 20 sont ici des microbolomètres comportant chacun une membrane absorbante 22, i.e. apte à absorber le rayonnement électromagnétique à détecter, suspendue au-dessus du substrat de lecture 11 par des piliers d'ancrage 21, et isolée thermiquement de celui-ci par des bras de maintien et d'isolation thermique. L'obtention de membranes absorbantes 22 est classiquement obtenue par des techniques de micro-usinage de surface consistant à réaliser les piliers d'ancrage 21 au travers d'une première couche sacrificielle minérale, et les bras d'isolation thermique ainsi que les membranes absorbantes 22 sur la face supérieure de la couche sacrificielle. Chaque membrane absorbante comporte en outre un transducteur thermométrique, par exemple un matériau thermistance relié au circuit de lecture par des connexions électriques prévues dans les bras d'isolation thermique et dans les piliers d'ancrage 21.

On dépose ensuite une deuxième couche sacrificielle minérale préférentiellement de même nature que la première couche sacrificielle minérale. La deuxième couche sacrificielle minérale recouvre la couche sacrificielle minérale ainsi que les détecteurs thermiques 20. Sur les figures, les deux couches sacrificielles minérales sont illustrées ensemble avec la référence 15.

On réalise ensuite la couche mince d'encapsulation 16 d'une structure d'encapsulation de manière similaire à celle décrite dans le document EP3239670A1, ceci pour chaque matrice de détecteurs thermiques 20. Tout d'abord, par des techniques classiques de photolithographie, on grave localement les couches sacrificielles minérales 15 pour former des tranchées débouchant sur le substrat de lecture 11. On procède ensuite au dépôt conforme de la couche mince d'encapsulation 16, ici du silicium amorphe, qui s'étend sur la couche sacrificielle minérale 15 ainsi que dans les tranchées, par exemple par un dépôt chimique en phase vapeur (CVD pour *Chemical Vapor Deposition,* en anglais). Bien entendu, la couche d'encapsulation 16 peut comporter des piliers de soutien, comme le décrit notamment le document EP3067674A2.

La couche mince d'encapsulation 16 comprend donc une partie supérieure 16.1 (également appelée paroi supérieure) qui s'étend au-dessus et à distance suivant l'axe Z des détecteurs thermiques 20, et une partie périphérique 16.2 (également appelée paroi périphérique) qui entoure dans le plan XY de manière continue les détecteurs thermiques 20. La paroi supérieure 16.1 repose donc sur et au contact de la couche sacrificielle minérale 15. La couche mince d'encapsulation 16 est destinée à délimiter la cavité 2 suivant la direction +Z et dans le plan XY.

Dans cet exemple, une même couche mince d'encapsulation 16 est déposée de manière à recouvrir continûment les différentes matrices de détecteurs thermiques 20 et à s'étendre dans les différentes tranchées. Aussi, les parois supérieures 16.1 qui s'étendent au-dessus des matrices de détecteurs thermiques 20 adjacentes sont reliées entre elles par une paroi supérieure intercalaire 16.3, laquelle surplombe ici les portions de connexion 13. Une cavité latérale 2.1 est alors formée entre deux cavités 2 adjacentes. Elle est délimitée par la paroi supérieure intercalaire 16.3 et par les parois périphériques 16.2 qui délimitent des deux cavités 2 adjacentes. Elle est remplie par les couches sacrificielles minérales 15. Elle peut s'étendre de manière à entourer dans le plan XY au moins en partie une même matrice de détecteurs thermiques 20. La couche mince d'encapsulation 16 s'étend donc continûment au-dessus et autour des détecteurs thermiques 20. La paroi supérieure 16.1 s'étend au-dessus des détecteurs thermiques 20, et la paroi périphérique 16.2 entoure les détecteurs thermiques 20 dans le plan XY. La paroi supérieure 16.1 et la paroi périphérique 16.2 sont donc réalisées d'un seul tenant et en le(s) même(s) matériau(x).

En variante, différentes couches minces d'encapsulation 16 peuvent être réalisées, lesquels sont alors distinctes les unes des autres, chacune étant propre à un dispositif de détection 1 différent. Pour cela, la paroi supérieure intercalaire 16.3 est gravée localement, de manière à individualiser les différentes couches minces d'encapsulation 16. Une ouverture périphérique peut alors être réalisée, de sorte que le matériau d'encapsulation ne s'étend pas au-dessus de la ou des portions de connexion 13.

En référence à la fig.1B, on réalise au moins une échancrure 4 dite latérale, par photolithographie et gravure dans la couche mince d'encapsulation 16 et dans une partie de la couche sacrificielle minérale 15. L'échancrure latérale 4 est réalisée par gravure sèche anisotrope (gravure physique), par exemple une gravure RIE. Les évents de libération 17.1 destinés à permettre l'évacuation des couches sacrificielles minérales 15 hors de la cavité 2 ne sont pas encore réalisés à ce stade.

L'échancrure latérale 4 est destinée à permettre l'introduction dans la cavité 2 d'au moins une portion getter 34 recouverte par une couche mince de protection 35, la portion getter 34 étant fixée à une couche mince de maintien 33 reportée et assemblée par collage direct à la couche mince d'encapsulation 16. L'échancrure latérale 4 présente des dimensions adaptées à celles de la portion getter 34 recouverte par la couche mince de protection 35 de manière à autoriser l'introduction de la portion getter 34 ainsi protégée dans l'espace délimité par l'échancrure latérale 4. De préférence, les dimensions de l'échancrure latérale 4 sont adaptées de sorte que, après report et collage direct, la couche mince de protection 35 est distante de la couche sacrificielle minérale 15, c'est-à-dire espacée de la couche sacrificielle minérale 15 dans le plan XY et suivant l'axe Z d'une distance non nulle.

L'échancrure latérale 4 est un évidemment réalisé à partir de la face supérieure du premier empilement suivant la direction -Z. Elle s'étend au travers de la couche mince d'encapsulation 16 suivant la direction -Z puis s'étend partiellement dans la couche sacrificielle minérale 15. Elle est espacée du substrat de lecture suivant l'axe Z par une partie de la couche sacrificielle minérale 15. Elle présente donc une surface de fond 4.1 définie par la surface supérieure de la couche sacrificielle minérale 15 et s'étendant de manière sensiblement parallèle au plan XY, et une surface de bordure 4.2 définie par la couche sacrificielle minérale 15 et par la couche mince d'encapsulation 16 et s'étendant de manière sensiblement parallèle à l'axe Z.

L'échancrure 4 est dite latérale dans la mesure où elle est distante des détecteurs thermiques 20 optiquement actifs dans un plan XY parallèle au plan du substrat de lecture 11, c'est-à-dire des détecteurs thermiques 20 destinés à détecter le rayonnement infrarouge, de manière à ce que la présence de la portion getter 34 ne perturbe pas la transmission du rayonnement électromagnétique à détecter. L'échancrure latérale 4 est donc espacée d'une distance non nulle de ces détecteurs thermiques 20, et plus précisément des membranes absorbantes 22, et de préférence également des bras d'isolation thermique et des piliers d'ancrage 21. Comme décrit plus loin, elle peut toutefois surplomber un détecteur thermique de compensation 7, c'est-à-dire un détecteur thermique dit aveugle dans la mesure où il est destiné à ne pas recevoir et détecter le rayonnement électromagnétique.

A titre d'exemple, l'échancrure latérale 4 présente des dimensions dans le plan XY et une profondeur suivant l'axe Z telles qu'elle peut recevoir une portion getter 34 recouverte par une couche mince de protection 35, moyennant une marge d'alignement lors du collage des empilements. Les dimensions de la portion getter 34 dans le plan XY dépendent de l'agencement de la portion getter vis-à-vis du ou des détecteurs. Elles peuvent ainsi être de l'ordre de plusieurs mm² pour, par exemple, s'étendre à la verticale de plusieurs détecteurs de compensation, voire présenter des dimensions bien plus petites, notamment lorsqu'une grille de portions getter est prévue. L'épaisseur de la portion getter peut être de l'ordre de 100nm à 1µm, typiquement 300nm. La couche mince de protection 35 peut présenter une épaisseur de quelques dizaines à centaines de nanomètres, typiquement 200nm.

En référence à la fig.1C, on réalise un deuxième empilement 30. Cette étape peut être effectuée avant, pendant ou après les étapes décrites précédemment. Le deuxième empilement 30 comporte :
- un substrat support 31, 32 ;
- une couche mince dite de maintien 33, reposant sur le substrat support, réalisée en un matériau transparent au rayonnement électromagnétique à détecter ;
- au moins une portion getter 34 disposée sur la couche mince de maintien 33, et recouvrant partiellement celle-ci ;
- une couche mince de protection 35, recouvrant la portion getter 34, réalisée en un matériau carboné adapté à être supprimé par une gravure chimique telle qu'une gravure par plasma O₂.

Le deuxième empilement 30 peut être réalisé à partir d'un substrat SOI ou d'un substrat GeOI. Le substrat support est alors formé d'un substrat 31 en silicium d'une épaisseur par exemple de quelques centaines de microns d'épaisseur, et d'une couche 32 d'oxyde enterré (BOX). La couche mince de maintien 33 peut être réalisée en silicium dans le cas du substrat SOI, ou en germanium dans le cas du substrat GeOI. Le matériau et l'épaisseur de la couche mince de maintien 33 sont choisis de sorte qu'elle est transparente au rayonnement électromagnétique à détecter. Elle peut ainsi présenter une épaisseur inférieure ou égale à 200µm, voire à 10µm, de préférence inférieure ou égale à 5µm, par exemple égale à 100nm environ.

Dans cet exemple, la couche mince d'encapsulation 16 est formée en un seul matériau, ici en silicium amorphe, de sorte que la paroi supérieure 16.1 et la paroi périphérique sont entièrement réalisées en silicium amorphe. La couche mince de maintien 33 est également formée en un seul matériau, ici en silicium (cas du substrat SOI) ou en germanium (cas du substrat GeOI). En variante, comme décrit plus loin, la couche mince d'encapsulation 16 et la couche mince de maintien 33 peuvent être au moins localement des multicouches, les surfaces destinées à être mises en contact étant alors formées par des sous-couches de collage.

La portion getter 34 est réalisée en un matériau présentant un effet getter, par exemple en titane. Elle est entièrement recouverte par la couche mince de protection 35 réalisée en un matériau carboné, laquelle est de préférence réalisée en carbone amorphe, et présente une épaisseur comprise entre quelques dizaines de nanomètres à quelques centaines de nanomètres, par exemple comprise entre 50 nm et 500nm, voire comprise entre 100 nm et 300 nm, de manière à obtenir un bon recouvrement de la portion getter 34.

Le matériau carboné, lorsqu'il s'agit de carbone amorphe, peut être déposé en couche mince par une technique de dépôt conforme, tel que le dépôt chimique en phase vapeur assistée par plasma (PECVD, pour *Plasma Enhanced Chemical Vapor Deposition,* en anglais), ou le dépôt physique en phase vapeur (PVD, pour *Physical Vapor Deposition,* en anglais) par exemple via la pulvérisation d'une cible carbone par faisceau d'ions (IBS). Dans le cas du polyimide, il peut être déposé par dispense puis centrifugation (*spin coating*)*.* La couche mince de protection 35 est déposée de manière à recouvrir entièrement la portion getter 34, mais ne s'étend ici sensiblement pas sur la couche mince de maintien 33 (sauf en bordure de la portion getter 34), de manière à laisser libre une surface de la couche mince de maintien 33 destinée à venir au contact de la couche mince d'encapsulation 16 lors de l'étape d'assemblage par collage direct.

Le matériau carboné est ainsi inerte vis-à-vis d'un agent de gravure utilisé lors de la gravure chimique effectuée ultérieurement pour supprimer les couches sacrificielles minérales 15, en particulier l'acide fluorhydrique en phase vapeur. C'est le cas du polyimide qui réagit peu avec l'acide fluorhydrique, de sorte qu'il n'est pas supprimé sur toute son épaisseur à l'issue de cette étape de gravure chimique humide, la portion getter 34 restant ainsi entièrement recouverte par une épaisseur non nulle de la couche mince de protection 35. C'est le cas également du carbone amorphe qui ne réagit sensiblement pas avec cet agent de gravure. Le matériau carboné est cependant apte à réagir vis-à-vis d'un agent de gravure utilisé lors de la gravure chimique effectuée ultérieurement pour supprimer cette couche mince de protection 35, en particulier vis-à-vis d'oxygène présent dans un plasma d'une gravure chimique sèche.

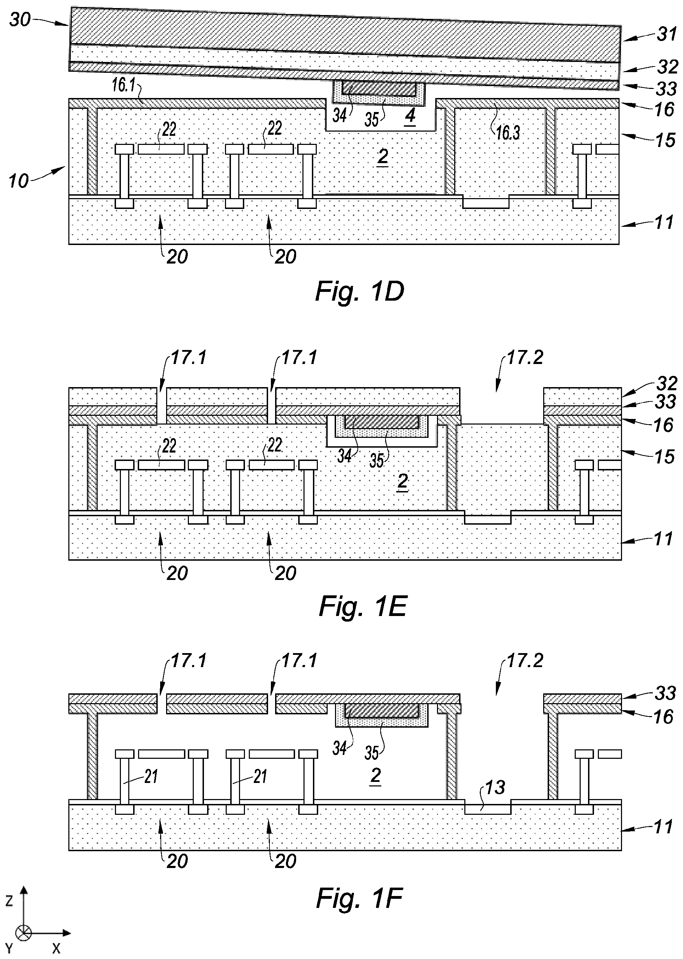

En référence à la fig.1D, on assemble le deuxième empilement 30 sur le premier empilement 10 par mise en contact sous vide et collage direct de la couche mince de maintien 33 avec la couche mince d'encapsulation 16. Dans cet exemple, la même couche mince de maintien 33 du deuxième empilement 30 est mise au contact des différentes parois supérieures 16.1, et ici de la paroi supérieure intercalaire 16.3.

Les surfaces mises en contact mutuel et assemblées par collage direct sont sensiblement planes. Aussi, au préalable, une étape de planarisation de la couche mince d'encapsulation 16 peut être effectuée avant la réalisation de l'échancrure latérale 4. Une étape de planarisation de la couche mince de maintien 33 peut également être effectuée avant la réalisation de la portion getter 34 et le dépôt de la couche mince de protection 35.

Le collage direct est de préférence un collage dit SAB (*Surface Activated Bonding,* en anglais). Cette technique de collage est notamment adaptée au collage direct de deux couches de silicium à température ambiante, sans matériau de collage intercalaire de type résine ou polymère. Pour ce type de collage direct, une pression lors du collage peut permettre d'augmenter l'énergie de collage. Cette technique de collage est notamment décrite dans la publication de Takagi et al. intitulée Surface activated bonding of silicon wafers at room temperature, Appl. Phys. Lett. 68, 2222 (1996). Elle permet également le collage direct d'une couche mince de maintien 33 en germanium sur la couche mince d'encapsulation 16 en silicium.

Pour cela, les faces libres (surfaces de contact) en silicium des parois supérieures 16.1 et de la couche mince de maintien 33 ont été préalablement activées par gravure partielle par faisceau d'ions, par exemple par faisceau d'atomes d'argon, ou He, Ne, Xe, Kr. Dans le cas où cette préparation de surface se traduit par une faible gravure, la couche mince de protection 35 assure une protection supplémentaire de la portion getter 34 lors de cette étape. Par ailleurs, les détecteurs thermiques 20 sont, à cette étape, entièrement recouverts par les couches sacrificielles minérales 15, et sont donc protégés d'une toute dégradation que pourrait causer la gravure partielle par faisceau d'argon.

La face libre en silicium (ou en germanium) de la couche mince de maintien 33 est donc mise directement au contact de la face supérieure en silicium de la paroi supérieure 16.1 de la couche mince d'encapsulation 16. La mise au contact des surfaces de contact en silicium est effectuée sous vide, de préférence avec une pression de niveau de vide inférieure ou égale à 10⁻⁷ mbar (soit 10⁻⁵ Pa). Une force de pression peut être exercée sur le substrat de report en direction de l'empilement capteur, par exemple comprise entre 0.05 et 1.6 MPa.

On obtient ainsi un collage direct entre les surfaces en contact par liaison covalente silicium/silicium ou en silicium/germanium. L'énergie de collage est élevée du fait de la solidarisation par liaisons covalentes, et l'herméticité de la cavité 2 est donc renforcée. Une adhérence au moins égale à 2 J/m² peut être obtenue à température ambiante. Un recuit de collage n'est alors pas nécessaire. Ainsi, on écarte les risques de dégradation du circuit de lecture qui seraient liés à un recuit à une température supérieure à la température du budget thermique d'un circuit de lecture CMOS contenu dans le substrat 11, qui est de l'ordre de 350°C à 400°C environ. De plus, l'interface de collage est formée ici par les surfaces silicium/silicium (ou silicium/germanium), et ne comporte pas d'oxyde susceptible de réduire la transmission du rayonnement lumineux en direction des détecteurs thermiques 20. Les performances du dispositif de détection 1 sont alors préservées.

Un écart de température peut être appliqué aux deux empilements 10, 30, afin de générer une contrainte mécanique en légère tension au sein du deuxième empilement 30, améliorant ainsi sa planéité, et réduisant la contrainte mécanique résiduelle après assemblage. Cet écart de température peut être supérieur à 0°C et inférieur ou égal à 150°C, et par exemple égal à 50°C environ, de manière à générer une contrainte en tension de l'ordre de 25 MPa au sein du deuxième empilement 30.

En référence à la fig.1E, on supprime avantageusement au moins une partie du substrat support du deuxième empilement 30, à savoir ici le substrat en silicium 31. Pour cela, on peut réaliser une abrasion (*grinding,* en anglais) d'une partie du substrat en silicium 31, jusqu'à obtenir une couche résiduelle de quelques microns d'épaisseur, suivie d'une gravure chimique de la couche résiduelle avec arrêt de gravure sur la couche d'oxyde 32. D'autres techniques sont possibles. La couche d'oxyde 32 est, par exemple, supprimée en même temps que les couches sacrificielles minérales 15.

On réalise ensuite des évents de libération 17.1 destinés à permettre l'évacuation des produits de gravure hors de la cavité 2 lors de la gravure chimique humide des couches sacrificielles minérales 15. Ils sont réalisés par gravure sèche anisotrope, par exemple par gravure RIE. Ils peuvent être disposés entre deux détecteurs thermiques 20 adjacents, ou être disposés en regard suivant l'axe Z des membranes absorbantes 22 comme décrit dans la demande EP3067675A1, ou de préférence au-dessus des piliers d'ancrage. Les membranes absorbantes 22 peuvent alors comporter une ouverture traversante située à la perpendiculaire d'un évent correspondant, tel que le décrit cette demande EP3067675A1. Les évents de libérations 17.1 s'étendent au travers de la couche d'oxyde 32 (le cas échéant), de la couche mince de maintien 33, et de la couche mince d'encapsulation 16, pour déboucher sur la couche sacrificielle minérale 15 sous-jacente. Un évent de libération latéral 17.2 est également réalisé au travers de la paroi supérieure intercalaire 16.3.

En référence à la fig. 1F, on effectue ensuite une gravure chimique adaptée à supprimer les couches sacrificielles minérales 15, ici une gravure chimique humide par attaque à l'acide fluorhydrique en phase vapeur. Les produits de la réaction chimique sont évacués au travers des évents de libération 17.1. Cette gravure chimique humide étant isotrope, on obtient la suspension des membranes absorbantes 22 et des bras d'isolation thermique, et on libère les piliers d'ancrage 21. Les parties de couches sacrificielles minérales 15 qui recouvrent la ou les portions de connexion 13 sont également supprimées lors de cette gravure chimique, ici au travers de l'évent de libération latéral 17.2.

Ainsi, la cavité 2 délimitée par la couche mince d'encapsulation 16 est libérée des couches sacrificielles minérales 15, dont les produits de gravure sont évacués au travers des évents de libération 17.1, 17.2. La couche d'oxyde 32 est supprimée dans le même temps. La couche mince d'encapsulation 16 est alors recouverte seulement de la couche mince de maintien 33. La portion getter 34, recouverte par sa couche mince de protection 35, est alors située dans la cavité 2 et suspendue au-dessus du substrat de lecture 11 par la couche mince de maintien 33.

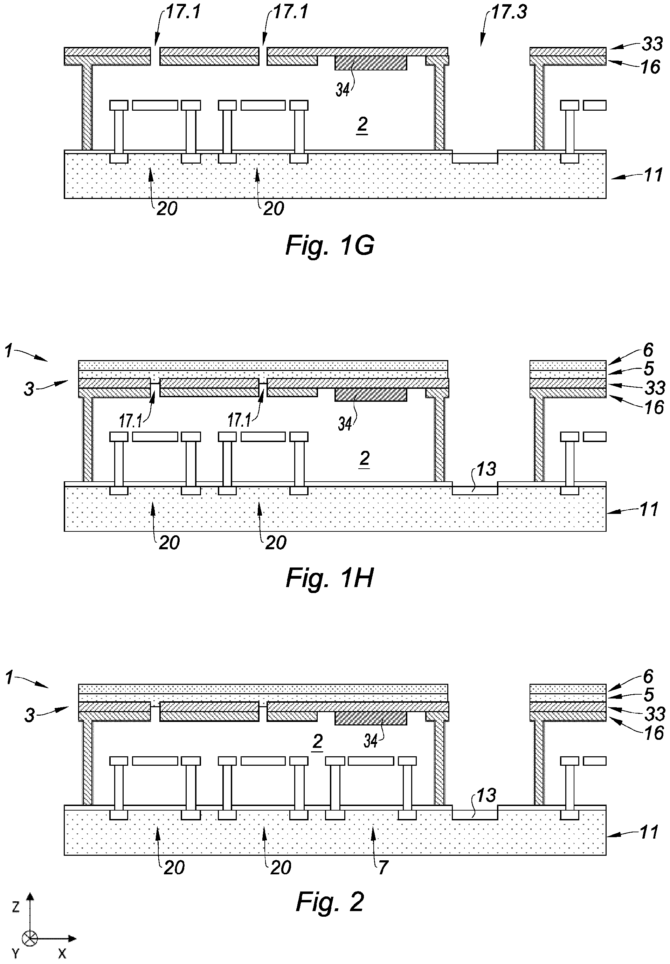

En référence à la fig.1G, on effectue une deuxième gravure chimique adaptée à supprimer la couche mince de protection 35 et rendre libre la surface de la portion getter 34. La gravure chimique est ici une gravure chimique sèche dont l'agent de gravure est de l'oxygène présent dans un plasma. Cette gravure chimique sèche étant isotrope, on préserve l'intégrité des structures libérées tout en facilitant l'accès à l'agent de gravure dans la cavité 2 au travers des évents de libération 17.1.

En référence à la fig.1H, on dépose une couche mince de scellement 5 sur la couche mince de maintien 33 avec une épaisseur suffisante pour assurer le scellement, ou bouchage, des évents de libération 17.1 débouchant dans la cavité 2. La couche mince de scellement 5 est transparente au rayonnement électromagnétique à détecter.

Elle est ici recouverte par une couche mince d'antireflet 6 pour optimiser la transmission du rayonnement au travers de la structure d'encapsulation. A ce titre, la couche mince de scellement 5 peut être réalisée en germanium de 1,7µm environ, et la couche mince d'antireflet 6 être réalisée en sulfure de zinc de 1,2µm environ dans le cas d'un rayonnement à détecter dans la gamme des longueurs d'onde allant de 8µm à 12µm. D'autres types de couches antireflet peuvent être utilisées.

Les couches minces de scellement 5 et d'antireflet 6 peuvent être déposées par une technique de dépôt de couches minces sous vide, comme l'évaporation sous vide d'une source chauffée par faisceau d'électrons (EBPVD) ou comme la pulvérisation, cathodique ou par faisceau d'ions. On obtient ainsi une cavité hermétique 2 sous vide ou pression réduite dans laquelle sont logés les détecteurs thermiques 20.

On grave localement les parties des couches minces de scellement 5 et d'antireflet 6 déposées sur le substrat de lecture 11, de manière à donner accès aux portions de connexion 13 et à rendre possible une connexion électrique, par exemple de type filaire (*wire bonding,* en anglais) entre les portions de connexion 13 et un dispositif électrique externe.

Par ailleurs, une étape de découpe de la structure générale ainsi obtenue peut être effectuée, de manière à dissocier les différents dispositifs de détection les uns des autres. Cette étape de découpe peut être effectuée suivant des lignes de découpe prédéfinies par les techniques connues, par exemple par découpe mécanique et/ou par laser, par gravure chimique, par gravure physique, ou autre.

On active la chimisorption de la portion getter 34 en soumettant le dispositif de détection 1 à un traitement thermique adéquat, dans un four ou une étuve, de manière à faire réagir le matériau getter avec des molécules de gaz résiduelles présentes dans la cavité hermétique et former ainsi des composés chimiques stables. On obtient ainsi un niveau de vide maintenu ou abaissé à l'intérieur de la cavité hermétique, améliorant ainsi la durée de vie du dispositif de détection.

Ainsi, le procédé de fabrication permet d'obtenir un dispositif de détection 1 comportant une structure d'encapsulation délimitant une cavité hermétique 2 dans laquelle se trouvent ici plusieurs détecteurs thermiques 20 ainsi qu'au moins une portion getter 34. La structure d'encapsulation est formée par une couche mince d'encapsulation 16 qui s'étend continûment au-dessus et autour des détecteurs thermiques 20, et par une couche mince de maintien 33 assemblée par collage direct à la couche mince d'encapsulation 16. Une portion getter 34 est fixée à la couche mince de maintien 33 et est introduite dans la cavité 2 lors du report, au travers de l'échancrure latérale 4 formée dans la couche mince d'encapsulation 16, laquelle est distante dans le plan XY vis-à-vis des détecteurs thermiques 20 optiquement actifs.

Ainsi, la structure d'encapsulation 3 présente une configuration simplifiée par rapport à celle du document EP3399290A1. Elle est formée des couches minces d'encapsulation 16, de maintien 33 et de scellement 5, et n'est donc pas formée d'une paroi périphérique, sur laquelle reposent des plots de collage en cuivre, un capot fin et une couche de scellement. De plus, l'assemblage du deuxième empilement 30 sur le premier empilement 10 ne nécessite pas d'utiliser le cuivre pour effectuer le collage direct, simplifiant ainsi le procédé de fabrication. Par ailleurs, on augmente la surface de collage dans la mesure où la surface de contact entre la couche mince d'encapsulation 16 et la couche mince de maintien 33 peut être importante, améliorant ainsi la tenue mécanique.

Par ailleurs, l'assemblage par collage de type SAB ou, comme décrit plus loin de type ADB, peut être effectué à température ambiante, tout en obtenant une qualité élevée d'herméticité de la cavité 2. On évite ainsi de dégrader le circuit de lecture présent dans le premier substrat 11, ou de provoquer une évolution non souhaitée des propriétés du getter. L'activation du getter peut d'ailleurs être effectuée avant ou après l'étape d'assemblage.

Le fait d'introduire la portion getter 34 dans la cavité 2 au moyen de la couche mince de maintien 33 permet de préserver le maintien mécanique des couches sacrificielles minérales 15 lors des étapes de planarisation des différentes couches sacrificielles minérales 15 déposées. On évite ainsi la fragilité mécanique mentionnée dans le document EP3239670A1 mise en évidence lors de la planarisation des couches sacrificielles minérales 15 lorsqu'elles reposent sur une couche mince de protection 35 en polyimide, dans le cas où la portion getter 34 est située sous un détecteur thermique et est protégée de l'attaque HF vapeur par la couche carbonée en polyimide. En effet, dans le cadre de l'invention, les couches sacrificielles minérales 15 ne reposent pas sur une couche sacrificielle carbonée qui protégerait une portion getter 34 reposant sur le substrat 11, de sorte que cette fragilité mécanique est ici écartée.

De plus, les couches sacrificielles minérales 15 sont réalisées dans le premier empilement 10, avant assemblage avec le deuxième empilement 20 qui comporte la couche mince de protection 35. Elles ne sont donc pas déposées sur et au contact de la couche mince de protection 35, comme dans le document EP3239670A1, ce qui permet de préserver le caractère inerte du carbone amorphe vis-à-vis de la gravure humide mise en œuvre pour supprimer les couches sacrificielles minérales 15. En effet, les inventeurs ont constaté que le dépôt d'une couche sacrificielle minérale 15 sur et au contact d'une couche de carbone amorphe peut conduire à dégrader le caractère inerte du carbone amorphe à la gravure humide telle que l'attaque HF vapeur.

Par ailleurs, la couche mince de protection 35 est avantageusement maintenue à distance de la couche sacrificielle minérale 15. Une lame d'air est alors située entre la couche mince de protection 35 et les couches sacrificielles minérales 15, qui présente une épaisseur entre les couches sacrificielles minérales 15 et la couche mince de protection 35. Cette lame d'air correspond à la tolérance suffisante vis-à-vis notamment des erreurs d'alignement.

Par ailleurs, la portion getter 34 n'est pas située en regard des membranes absorbantes 22 comme c'est le cas dans le document EP3239670A1, ce qui autorise d'utiliser une surface de matériau getter plus importante. De plus, le matériau getter peut être choisi uniquement en fonction de sa propriété de chimisorption, et non pas en fonction d'une propriété supplémentaire de réflecteur optique. Un matériau getter à haute performance de chimisorption peut donc être choisi.

La figure 2 est une vue en coupe, schématique et partielle, d'un dispositif de détection 1 obtenu par un procédé de fabrication selon une variante du premier mode de réalisation.

Ici, le dispositif de détection 1 diffère de ceux décrits précédemment essentiellement en ce qu'il comporte au moins un détecteur thermique de compensation 7, disposé dans une cavité hermétique 2, en regard duquel est disposé la portion getter 34. Ainsi, la portion getter 34 est disposée à distance des détecteurs thermiques 20 destinés à détecter le rayonnement électromagnétique, de manière à ne pas perturber la transmission du rayonnement électromagnétique en direction de ces détecteurs thermiques 20. Cependant, il est disposé en regard du détecteur thermique de compensation 7, et notamment en regard de toute sa membrane suspendue, de manière à bloquer la transmission du rayonnement électromagnétique en direction de ce détecteur thermique 7. La portion getter 34 est donc réalisée en un matériau et d'une épaisseur tels qu'elle ne transmet pas le rayonnement électromagnétique à détecter. Autrement dit, la portion getter 34 est opaque au rayonnement électromagnétique à détecter.

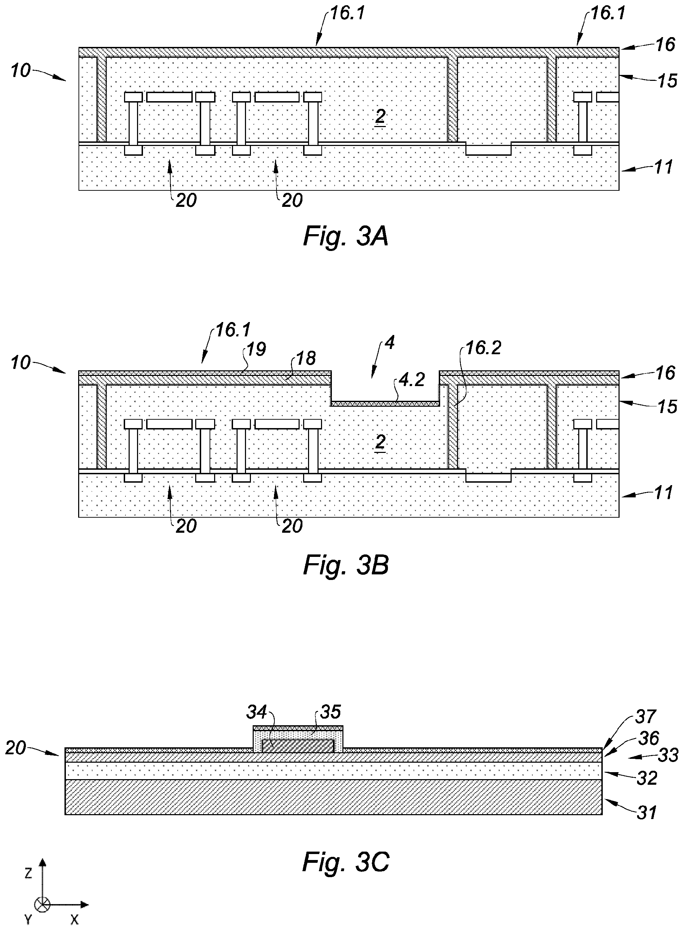

Les figures 3A à 3F illustrent différentes étapes d'un procédé de fabrication selon un deuxième mode de réalisation dans lequel le collage direct est de type ADB (*Atomic Diffusion Bonding*)*.* Cette technique de collage est notamment adaptée au collage de deux sous-couches à température ambiante, sans matériau de collage intercalaire de type résine ou polymère. Elle est notamment décrite dans la publication de Shimatsu et Uomoto intitulée Atomic diffusion bonding of wafers with thin nanocrystalline metal films, J. Vac. Sci. Technol. B 28, 706 (2010).

Pour cela, les surfaces de collage de la couche mince d'encapsulation 16 et de la couche mince de maintien 33 sont formées par des sous-couches de collage 19, 37, de préférence en titane Ti ou en carbone amorphe, d'une épaisseur choisie pour limiter l'absorption du rayonnement électromagnétique à détecter, par exemple d'une épaisseur inférieure ou égale à 1nm, par exemple égale à 0.5nm. Le carbone amorphe est avantageux du fait de sa sélectivité plus importante (caractère inerte) vis-à-vis de la gravure humide à l'HF vapeur que le titane. Lors de la gravure à l'HF vapeur, l'éventuelle gravure des sous-couches de collage à partir des évents reste limitée.

En référence à la fig.3A, on réalise un premier empilement 10 ici similaire à celui décrit en référence à la fig. 1A. Cette étape est identique ou similaire à celle décrite précédemment, et n'est pas détaillée à nouveau.

En référence à la fig.3B, on réalise l'échancrure latérale 4, de manière identique ou similaire à l'étape décrite en référence à la fig.1B. Ensuite, on dépose une sous-couche de collage 19, par dépôt physique en phase vapeur (évaporation, pulvérisation...) sous vide, par exemple avec une pression inférieure ou égale à 2×10⁻⁶Pa, de manière à recouvrir la face supérieure de la couche mince d'encapsulation 16. Une sous-couche de collage 19 est ici déposée également sur la surface de fond 4.2 de l'échancrure latérale 4. En variante, la sous-couche de collage 19 peut être déposée avant la réalisation de l'échancrure latérale 4. La paroi supérieure 16.1 de la couche mince d'encapsulation 16 est donc formée d'une sous-couche 19, par exemple en silicium, réalisée d'un seul tenant avec la paroi périphérique 16.2, et d'une sous-couche de collage 19.

En référence à la fig.3C, on réalise un deuxième empilement 30 similaire à celui décrit précédemment. Cependant, une deuxième sous-couche de collage 37, de préférence identique en épaisseur et en matériau à la première sous-couche de collage 19, est déposée sur la couche mince de maintien 33 et ici sur la couche mince de protection 35. Il s'agit ici d'une couche mince 37 de titane ou de carbone amorphe d'une épaisseur de 0.5nm environ. Plus précisément, la couche mince de maintien 33 est formée d'une sous-couche 36 en silicium (substrat SOI) ou en germanium (substrat GeOI) et de la deuxième sous-couche de collage 37. Une partie de la sous-couche de collage 37 est déposée sur la face supérieure de la couche mince de protection 35.

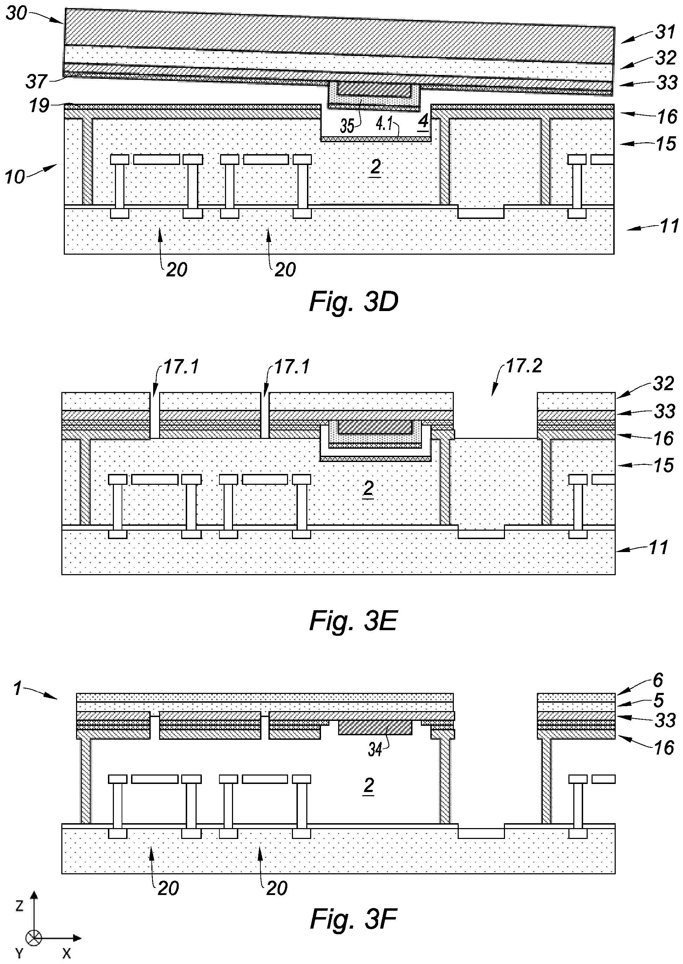

En référence à la fig.3D, le deuxième empilement 30 est assemblé sur le premier empilement 10, par mise en contact sous vide des deux sous-couches de collage 19, 37 qui recouvrent respectivement la sous-couche 18 et la sous-couche 36, ceci à température ambiante. Ces sous-couches de collage 19, 37 étant formées d'un matériau nanocristallin, c'est-à-dire cristallin d'une épaisseur de l'ordre de, au plus, quelques nanomètres, le collage direct entre ces deux surfaces métalliques est obtenu. La diffusion atomique à l'interface de collage permet d'obtenir une herméticité renforcée de la cavité 2. La partie de la sous-couche de collage 37 qui recouvre la couche mince de protection 35 reste ici espacée d'une distance non nulle, suivant l'axe Z, vis-à-vis de la partie de la sous-couche de collage 19 qui est située sur la surface de fond 4.2 de l'échancrure latérale 4.

En référence à la fig.3E, on réalise les évents de libération 17.1 débouchant sur la couche sacrificielle minérale 15 située dans la cavité 2, ainsi qu'un évent latéral 17.2 débouchant dans la cavité latérale 2.1.

En référence à la fig.3F, on effectue la gravure chimique humide pour supprimer les couches sacrificielles minérales 15 et ainsi la couche d'oxyde 32. La partie de la sous-couche de collage 37 recouvrant la couche mince de protection 35 est ici supprimée lorsqu'elle est réalisée en titane. On effectue ensuite la gravure chimique sèche de manière à supprimer la couche mince de protection 35. La partie de la sous-couche de collage 37 recouvrant la couche mince de protection 35, lorsqu'elle est réalisée en carbone amorphe, est supprimée lors de cette étape de gravure chimique sèche. Ainsi, la surface de la portion getter 34 est rendue libre. On dépose ensuite la couche mince de scellement 5, et ici la couche mince antireflet 6.

Des modes de réalisation particuliers viennent d'être décrits. Différentes variantes et modifications apparaîtront à l'homme du métier. Il est possible de structurer la face inférieure de la couche mince d'encapsulation 16, notamment comme le décrit le document EP3196615, pour lui ajouter une fonction optique (antireflet...), améliorant ainsi les performances du dispositif de détection.

## Revendications

1. Procédé de fabrication d'un dispositif de détection (1) d'un rayonnement électromagnétique, comportant les étapes suivantes :
∘ réalisation d'un premier empilement (10) comportant :
• au moins un détecteur thermique (20) reposant sur un premier substrat (11), destiné à détecter le rayonnement électromagnétique, et recouvert par au moins une couche sacrificielle minérale (15) réalisée en un matériau minéral apte à être supprimé par une première gravure chimique ;
• une couche mince d'encapsulation (16), s'étendant au-dessus du détecteur thermique (20) et participant à délimiter une cavité (2) dans laquelle se situe le détecteur thermique (20), comportant une partie supérieure (16.1) reposant sur la couche sacrificielle minérale (15) ;
- au moins une échancrure dite latérale (4) s'étendant au travers de la partie supérieure (16.1) de la couche mince d'encapsulation (16) et d'une partie de la couche sacrificielle minérale (15), et étant située à distance du détecteur thermique (20) dans un plan parallèle au plan du premier substrat (11) ;
∘ réalisation d'un deuxième empilement (30) comportant :
• une couche mince dite de maintien (33), transparente au rayonnement électromagnétique, reposant sur un substrat support (31, 32),
• au moins une portion getter (34) disposée sur la couche mince de maintien (33) et recouvrant partiellement celle-ci, et
• une couche mince de protection (35), recouvrant la portion getter (34), réalisée en un matériau carboné apte à être supprimé par une deuxième gravure chimique ;
∘ assemblage des premier et deuxième empilements (10, 30), par mise en contact et collage direct de la couche mince de maintien (33) sur la partie supérieure (16.1) de la couche mince d'encapsulation (16), de sorte que la portion getter (34) est située dans l'échancrure latérale (4) ; puis
∘ réalisation d'au moins un évent de libération (17) au travers de la couche mince de maintien (33) et de la partie supérieure (16.1) de la couche mince d'encapsulation (16), débouchant sur la couche sacrificielle minérale (15) ; puis
∘ suppression de la couche sacrificielle minérale (15) par la première gravure chimique ;
∘ suppression de la couche mince de protection (35) par la deuxième gravure chimique ;
∘ dépôt d'une couche mince de scellement (5) sur la couche mince de maintien (33) de manière à obturer l'évent de libération (17).

2. Procédé selon la revendication 1, dans lequel l'étape d'assemblage est effectuée à température ambiante avec une pression de niveau de vide inférieure ou égale à 10⁻⁵ Pa.

3. Procédé selon la revendication 1 ou 2, dans lequel le matériau carboné de la couche mince de protection (35) est choisi parmi le carbone amorphe et le polyimide.

4. Procédé selon l'une quelconque des revendications 1 à 3, dans lequel l'échancrure latérale (4) présente des dimensions telles que, lors de l'étape d'assemblage, la couche mince de protection (35) est distante de la couche sacrificielle minérale (15).

5. Procédé selon l'une quelconque des revendications 1 à 4, dans lequel la couche mince d'encapsulation (16) est réalisée à base de silicium, et la couche mince de maintien (33) est réalisée à base de silicium ou de germanium.

6. Procédé selon l'une quelconque des revendications 1 à 5, dans lequel la couche mince d'encapsulation (16) présente une surface de contact en silicium, et la couche mince de maintien (33) présente une surface de contact en silicium ou en germanium, et dans lequel l'étape d'assemblage par collage direct comporte une activation desdites surfaces de contact par gravure partielle par faisceau d'ions et un collage sous vide.

7. Procédé selon l'une quelconque des revendications 1 à 5, dans lequel la partie supérieure (16.1) de la couche mince d'encapsulation (16) est formée d'une sous-couche (18) réalisée en silicium et d'une première sous-couche de collage (19), et la couche mince de maintien (33) étant formée d'une sous-couche (36) réalisée à base de silicium ou en germanium et d'une deuxième sous-couche de collage (37), les deux sous-couches de collage (19, 37) étant transparentes au rayonnement électromagnétique à détecter, et dans lequel l'étape d'assemblage par collage direct comporte la mise en contact des deux sous-couches métalliques (19, 37) l'une contre l'autre sous vide.

8. Procédé selon la revendication 7, dans lequel lesdites sous-couches de collage (19, 37) présentent chacune une épaisseur inférieure ou égale à 1nm.

9. Procédé selon la revendication 7 ou 8, dans lequel lesdites sous-couches de collage (19, 37) sont réalisées en un matériau métallique ou en carbone amorphe.

10. Procédé selon l'une quelconque des revendications 1 à 9, dans lequel le premier empilement (10) comporte plusieurs matrices de détecteurs thermiques (20), chaque matrice étant située dans une cavité distincte (2) délimitée au moins en partie par une couche mince d'encapsulation (16), la couche mince de maintien (33) venant au contact des parties supérieures (16.1) des différentes couches minces d'encapsulation (16).

11. Procédé selon l'une quelconque des revendications 1 à 10, dans lequel la portion getter (34) est disposée en regard d'un détecteur thermique dit de compensation (7) destiné à ne pas recevoir le rayonnement électromagnétique, la portion getter (34) étant opaque au rayonnement électromagnétique.

12. Dispositif de détection (1) d'un rayonnement électromagnétique, comportant :
∘ un substrat (11) ;
∘ au moins un détecteur thermique (20) reposant sur le substrat (11), destiné à détecter le rayonnement électromagnétique ;
∘ une couche mince d'encapsulation (16), s'étendant continûment au-dessus et autour du détecteur thermique (20), et participant à délimiter une cavité (2) dans laquelle se situe le détecteur thermique (20), comportant une partie supérieure (16.1) s'étendant au-dessus du détecteur thermique (20), et une partie périphérique (16.2) s'étendant autour du détecteur thermique (20) dans un plan parallèle au substrat (11) ;
• au moins une échancrure dite latérale (4) s'étendant au travers de la partie supérieure (16.1) de la couche mince d'encapsulation (16), et située à distance du détecteur thermique (20) dans un plan parallèle au plan du substrat (11) ;
∘ une couche mince dite de maintien (33), transparente au rayonnement électromagnétique, reposant au contact de la partie supérieure (16.1) de la couche mince d'encapsulation (16), la couche mince de maintien (33) présentant une face supérieure plane opposée au substrat (11) ;
∘ au moins une portion getter (34) assemblée à la couche mince de maintien (33) et disposée dans l'échancrure latérale (4) ;
∘ au moins un évent de libération (17) s'étendant au travers de la couche mince de maintien (33) et de la partie supérieure (16.1) de la couche mince d'encapsulation (16) ;
∘ une couche mince de scellement (5) recouvrant la couche mince de maintien (33) et obturant l'évent de libération (17).

## Patentansprüche

1. Verfahren zur Herstellung einer Detektionsvorrichtung (1) zur Detektion einer elektromagnetischen Strahlung, umfassend die folgenden Schritte:
∘ Ausführen eines ersten Stapels (10), umfassend:
• mindestens einen thermischen Detektor (20), der auf einem ersten Substrat (11) ruht, dazu bestimmt ist, die elektromagnetische Strahlung zu detektieren, und mit mindestens einer mineralischen Opferschicht (15) bedeckt ist, die geeignet ist, durch eine erste chemische Ätzung entfernt zu werden;
• eine dünne Kapselungsschicht (16), die sich über dem thermischen Detektor (20) erstreckt und dazu beiträgt, einen Hohlraum (2) zu begrenzen, in dem der thermische Detektor (20) gelegen ist, umfassend einen oberen Teil (16.1), der auf der mineralischen Opferschicht (15) ruht;
- mindestens einen sogenannten seitlichen Ausschnitt (4), der sich durch den oberen Teil (16.1) der dünnen Kapselungsschicht (16) und einen Teil der mineralischen Opferschicht (15) hindurch erstreckt und vom thermischen Detektor (20) beabstandet in einer Ebene parallel zur Ebene des ersten Substrats (11) gelegen ist;
∘ Ausführen eines zweiten Stapels (30), umfassend:
• eine dünne sogenannte Erhaltungsschicht (33), die für die elektromagnetische Strahlung durchlässig ist und auf einem Trägersubstrat (31, 32) ruht,
• mindestens einen Getter-Abschnitt (34), der auf der dünnen Erhaltungsschicht (33) angeordnet ist und diese teilweise bedeckt, und
• eine dünne Schutzschicht (35), die den Getter-Abschnitt (34) bedeckt und aus einem kohlenstoffhaltigen Material ausgeführt ist, das geeignet ist, durch eine zweite chemische Ätzung entfernt zu werden;
∘ Verbinden der ersten und zweiten Stapel (10, 30) durch Kontaktieren und direktes Kleben der dünnen Erhaltungsschicht (33) auf den oberen Teil (16.1) der dünnen Kapselungsschicht (16), so dass der Getter-Abschnitt (34) in dem seitlichen Ausschnitt (4) gelegen ist; dann
∘ Ausführen mindestens einer Auslassöffnung (17) durch die dünne Erhaltungsschicht (33) und den oberen Teil (16.1) der dünnen Kapselungsschicht (16) hindurch, die auf der mineralischen Opferschicht (15) mündet; dann
∘ Entfernen der mineralischen Opferschicht (15) durch die erste chemische Ätzung;
∘ Entfernen der dünnen Schutzschicht (35) durch die zweite chemische Ätzung;
∘ Abscheiden einer dünnen Versiegelungsschicht (5) auf der dünnen Erhaltungsschicht (33), so dass die Auslassöffnung (17) verschlossen wird.

2. Verfahren nach Anspruch 1, bei dem der Schritt des Verbindens bei Umgebungstemperatur mit einem Vakuumniveaudruck kleiner oder gleich 10⁻⁵ Pa erfolgt.

3. Verfahren nach Anspruch 1 oder 2, bei dem das kohlenstoffhaltige Material der dünnen Schutzschicht (35) unter amorphem Kohlenstoff und Polyimid gewählt wird.

4. Verfahren nach einem der Ansprüche 1 bis 3, bei dem der seitliche Ausschnitt (4) derartige Abmessungen aufweist, dass beim Schritt des Verbindens die dünne Schutzschicht (35) von der mineralischen Opferschicht (15) beabstandet ist.

5. Verfahren nach einem der Ansprüche 1 bis 4, bei dem die dünne Kapselungsschicht (16) auf der Basis von Silicium ausgeführt ist und die dünne Erhaltungsschicht (33) auf der Basis von Silicium oder Germanium ausgeführt ist.

6. Verfahren nach einem der Ansprüche 1 bis 5, bei dem die dünne Kapselungsschicht (16) eine Kontaktfläche aus Silicium aufweist und die dünne Erhaltungsschicht (33) eine Kontaktfläche aus Silicium oder aus Germanium aufweist und bei dem der Schritt des Verbindens durch direktes Kleben eine Aktivierung der Kontaktflächen durch teilweises Ionenstrahlätzen und ein Kleben unter Vakuum umfasst.

7. Verfahren nach einem der Ansprüche 1 bis 5, bei dem der obere Teil (16.1) der dünnen Kapselungsschicht (16) aus einer aus Silicium ausgeführten Teilschicht (18) und aus einer ersten Klebeteilschicht (19) gebildet ist und die dünne Erhaltungsschicht (33) aus einer auf der Basis von Silicium oder aus Germanium ausgeführten Teilschicht (36) und aus einer zweiten Klebeteilschicht (37) gebildet ist, wobei die beiden Klebeteilschichten (19, 37) für die zu detektierende elektromagnetische Strahlung durchlässig sind, und wobei der Schritt des Verbindens durch direktes Kleben das Kontaktieren der beiden metallischen Teilschichten (19, 37) gegeneinander unter Vakuum umfasst.

8. Verfahren nach Anspruch 7, bei dem die Klebeteilschichten (19, 37) jeweils eine Dicke kleiner oder gleich 1 nm aufweisen.

9. Verfahren nach Anspruch 7 oder 8, bei dem die Klebeteilschichten (19, 37) aus einem metallischen Material oder aus amorphem Kohlenstoff ausgeführt sind.

10. Verfahren nach einem der Ansprüche 1 bis 9, bei dem der erste Stapel (10) mehrere Matrizen aus thermischen Detektoren (20) umfasst, wobei jede Matrix in einem separaten Hohlraum (2) gelegen ist, der mindestens teilweise durch eine dünne Kapselungsschicht (16) begrenzt wird, wobei die dünne Erhaltungsschicht (33) mit den oberen Teilen (16.1) der verschiedenen dünnen Kapselungsschichten (16) in Kontakt kommt.

11. Verfahren nach einem der Ansprüche 1 bis 10, bei dem der Getter-Abschnitt (34) gegenüber einem sogenannten thermischen Kompensationsdetektor (7) angeordnet ist, der dazu bestimmt ist, die elektromagnetische Strahlung nicht zu empfangen, wobei der Getter-Abschnitt (34) für die elektromagnetische Strahlung undurchlässig ist.

12. Detektionsvorrichtung (1) zur Detektion einer elektromagnetischen Strahlung, umfassend:
∘ ein Substrat (11);
∘ mindestens einen thermischen Detektor (20), der auf dem Substrat (11) ruht und dazu bestimmt ist, die elektromagnetische Strahlung zu detektieren;
∘ eine dünne Kapselungsschicht (16), die sich durchgehend über dem und um den thermischen Detektor (20) herum erstreckt und dazu beiträgt, einen Hohlraum (2) zu begrenzen, in dem der thermische Detektor (20) gelegen ist, umfassend einen oberen Teil (16.1), der sich über dem thermischen Detektor (20) erstreckt, und einen Randteil (16.2), der sich um den thermischen Detektor (20) herum in einer Ebene parallel zum Substrat (11) erstreckt;
• mindestens einen sogenannten seitlichen Ausschnitt (4), der sich durch den oberen Teil (16.1) der dünnen Kapselungsschicht (16) hindurch erstreckt und vom thermischen Detektor (20) beabstandet in einer Ebene parallel zur Ebene des Substrats (11) gelegen ist;
∘ eine dünne sogenannte Erhaltungsschicht (33), die für die elektromagnetische Strahlung durchlässig ist, wobei sie im Kontakt mit dem oberen Teil (16.1) der dünnen Kapselungsschicht (16) ruht, wobei die dünne Erhaltungsschicht (33) eine plane Oberseite aufweist, die entgegengesetzt zum Substrat (11) ist;
∘ mindestens einen Getter-Abschnitt (34), der mit der dünnen Erhaltungsschicht (33) verbunden ist und in dem seitlichen Ausschnitt (4) angeordnet ist;
∘ mindestens eine Auslassöffnung (17), die sich durch die dünne Erhaltungsschicht (33) und den oberen Teil (16.1) der dünnen Kapselungsschicht (16) hindurch erstreckt;
∘ eine dünne Versiegelungsschicht (5), die die dünne Erhaltungsschicht (33) bedeckt und dabei die Auslassöffnung (17) verschließt.

## Claims

1. Method for fabricating a device (1) for detecting electromagnetic radiation comprising the following steps:
∘ forming a first stack (10), comprising:
• at least one thermal detector (20) resting on a first substrate (11), intended to detect the electromagnetic radiation, and covered with at least one mineral sacrificial layer (15) made of a mineral material that can be eliminated by a first chemical etching;
• a thin encapsulation layer (16), extending above the thermal detector (20) and contributing to the delimiting of a cavity (2) in which the thermal detector (20) is located, comprising an upper part (16.1) resting on the mineral sacrificial layer (15);
- at least one indentation, called a lateral indentation (4), extending through the upper part (16.1) of the thin encapsulation layer (16) and part of the mineral sacrificial layer (15), and being located at a distance from the thermal detector (20) in a plane parallel to the plane of the first substrate (11);
∘ forming a second stack (30), comprising:
• a thin layer called the supporting layer (33), transparent to the electromagnetic radiation, resting on a supporting substrate (31, 32),
• at least one getter portion (34) positioned on the thin supporting layer (33) and partially covering the latter, and
• a thin protective layer (35), covering the getter portion (34), made of a carbonaceous material that can be eliminated by a second chemical etching;
∘ assembling the first and second stacks (10, 30) by bringing the thin supporting layer (33) into contact with the upper part (16.1) of the thin encapsulation layer (16) and directly bonding it thereto, so that the getter portion (34) is located in the lateral indentation (4); then
∘ forming at least one release vent (17) through the thin supporting layer (33) and the upper part (16.1) of the thin encapsulation layer (16), opening onto the mineral sacrificial layer (15); then
∘ eliminating the mineral sacrificial layer (15) by the first chemical etching;
∘ eliminating the thin protective layer (35) by the second chemical etching;
∘ depositing a thin sealing layer (5) on the thin supporting layer (33) so as to block the release vent (17).

2. Method according to Claim 1, wherein the assembly step is carried out at ambient temperature with a vacuum pressure less than or equal to 10⁻⁵ Pa.

3. Method according to Claim 1 or 2, wherein the carbonaceous material of the thin protective layer (35) is chosen from amorphous carbon and polyimide.

4. Method according to any one of Claims 1 to 3, wherein the lateral indentation (4) has dimensions such that, in the assembly step, the thin protective layer (35) is at a distance from the mineral sacrificial layer (15).

5. Method according to any one of Claims 1 to 4, wherein the thin encapsulation layer (16) is silicon-based, and the thin supporting layer (33) is silicon- or germanium-based.

6. Method according to any one of Claims 1 to 5, wherein the thin encapsulation layer (16) has a contact surface made of silicon, and the thin supporting layer (33) has a contact surface made of silicon or germanium, and wherein the step of assembly by direct bonding comprises activation of said contact surfaces by partial ion beam etching and vacuum bonding.

7. Method according to any one of Claims 1 to 5, wherein the upper part (16.1) of the thin encapsulation layer (16) is formed by a sub-layer (18) made of silicon and a first bonding sub-layer (19), and the thin supporting layer (33) being formed by a silicon- or germanium-based sub-layer (36) and a second bonding sub-layer (37), the two bonding sub-layers (19, 37) being transparent to the electromagnetic radiation to be detected, and wherein the step of assembly by direct bonding comprises bringing the two metallic sub-layers (19, 37) into contact with one another under a vacuum.

8. Method according to Claim 7, wherein said bonding sub-layers (19, 37) each have a thickness less than or equal to 1 nm.

9. Method according to Claim 7 or 8, wherein said bonding sub-layers (19, 37) are made of a metallic material or of amorphous carbon.

10. Method according to any one of Claims 1 to 9, wherein the first stack (10) comprises a plurality of arrays of thermal detectors (20), each array being located in a distinct cavity (2) delimited at least partially by a thin encapsulation layer (16), the thin supporting layer (33) coming into contact with the upper parts (16.1) of the different thin encapsulation layers (16).

11. Method according to any one of Claims 1 to 10, wherein the getter portion (34) is located facing a thermal detector called a compensation detector (7), which is intended not to receive the electromagnetic radiation, the getter portion (34) being opaque to the electromagnetic radiation.

12. Device (1) for detecting electromagnetic radiation, comprising:
∘ a substrate (11);
∘ at least one thermal detector (20) resting on the substrate (11) and intended to detect the electromagnetic radiation;
∘ a thin encapsulation layer (16), extending continuously above and around the thermal detector (20) and contributing to the delimiting of a cavity (2) in which the thermal detector (20) is located, comprising an upper part (16.1) extending above the thermal detector (20) and a peripheral part (16.2) extending around the thermal detector (20) in a plane parallel to the substrate (11);
• at least one indentation, called a lateral indentation (4), extending through the upper part (16.1) of the thin encapsulation layer (16), and located at a distance from the thermal detector (20) in a plane parallel to the plane of the substrate (11);
∘ a thin layer called the supporting layer (33), transparent to the electromagnetic radiation, resting in contact with the upper part (16.1) of the thin encapsulation layer (16), the thin supporting layer (33) having a flat upper surface opposite the substrate (11);
∘ at least one getter portion (34) assembled onto the thin supporting layer (33) and positioned in the lateral indentation (4);
∘ at least one release vent (17) extending through the thin supporting layer (33) and the upper part (16.1) of the thin encapsulation layer (16);
∘ a thin sealing layer (5) covering the thin supporting layer (33) and blocking the release vent (17).
